# EUROPÄISCHE PATENTANMELDUNG

(11) **EP 3 598 652 A1**
(43) Veröffentlichungstag der Anmeldung: **22.01.2020**
(21) Anmeldenummer: 19185432.2
(22) Anmeldetag: 10.07.2019
(51) Int. Cl.: H04B 1/18, H03J 1/00

(54) **MONTAGEBAUTEIL**

(30) Priorität: 18.07.2018 DE 102018117416
(71) Anmelder: Huf Hülsbeck & Fürst GmbH & Co. KG, 42551 Velbert (DE)
(72) Erfinder: SIEG, Berthold, 46240 Bottrop (DE)
(74) Vertreter: Patentanwälte Bals & Vogel

(57) **Zusammenfassung**

Die Erfindung betrifft ein Montagebauteil (100), insbesondere ein Türgriff (3), für ein Fahrzeug (1) zur kontaktlosen Datenübertragung zwischen dem Fahrzeug (1) und einem mobilen Gerät (200), vorzugsweise zur NFC-Kommunikation, aufweisend:
- wenigstens ein elektronisches Verarbeitungsmittel (50) zum Empfangen und/oder Aussenden von Signalen für die Datenübertragung über eine Antenne (80),
- wenigstens einen Übertragungspfad (14), um die Antenne (80) für die Datenübertragung mit dem Verarbeitungsmittel (50) zu verbinden,
- eine Filterschaltung (20), welche zumindest zur Bereitstellung einer Bandpass-Filterung in den wenigstens einen Übertragungspfad (14) integriert ist,
- wenigstens eine elektrische Toleranzkompensationseinheit (60), um Toleranzabweichungen der Filterschaltung (20) auszugleichen.

## Beschreibung

Die vorliegende Erfindung betrifft ein Montagebauteil zur kontaktlosen Datenübertragung zwischen einem Fahrzeug und einem mobilen Gerät.

Aus dem Stand der Technik ist es bekannt, dass bei elektronischen Schaltungen zur kontaktlosen Datenübertragung Filterschaltungen in Montagebauteilen genutzt werden. Diese sind insbesondere an einen bestimmten Frequenzbereich für die Datenübertragung angepasst. Hierzu kann eine solche Filterschaltung bspw. als Bandpass und/oder Bandfilter ausgeführt sein, um Frequenzen außerhalb dieses Frequenzbereichs (unterhalb und oberhalb eines Durchlassbereiches der Filterschaltung) zu sperren und/oder abzuschwächen.

Allerdings ist hierbei ein Problem, dass aufgrund von Bauteiltoleranzen es zu Abweichungen der Filtereigenschaften nach der Herstellung kommen kann. Da hierbei ggf. nicht mehr die gewünschten Frequenzen durchgelassen werden und/oder die gewünschten Frequenzen abgeschwächt werden, kann es zu einer Beeinträchtigung der Datenübertragung und/oder zu einem erhöhten Energieverbrauch kommen.

Die toleranzbedingten Abweichungen können z. B. durch herstellungsbedingte Abweichungen der Bauelemente oder durch weitere Einflüsse, wie Temperatureinflüsse, begründet sein. Eine Reduzierung dieser Abweichungen kann daher technisch aufwendig und damit auch kostenaufwendig sein.

Es ist daher eine Aufgabe der vorliegenden Erfindung, die voranstehend genannten Nachteile zumindest teilweise zu reduzieren. Insbesondere ist es eine Aufgabe, ein verbessertes Montagebauteil zur kontaktlosen Datenübertragung bereitzustellen.

Die voranstehende Aufgabe wird gelöst durch ein Montagebauteil mit den Merkmalen des unabhängigen Vorrichtungsanspruchs. Weitere Merkmale und Details der Erfindung ergeben sich aus den jeweiligen Unteransprüchen, der Beschreibung und den Zeichnungen.

Die Aufgabe wird insbesondere gelöst durch ein Montagebauteil, welches vorzugsweise einzeln handhabbar am Fahrzeug montierbar ist.

Das Montagebauteil kann z. B. als ein Türgriff oder als ein Stoßfänger oder als ein Elektronikbauteil für ein Fahrzeug ausgebildet sein und/oder zur kontaktlosen Datenübertragung zwischen dem Fahrzeug und einem mobilen Gerät, vorzugsweise zur NFC-Kommunikation, dienen. NFC steht hierbei für "Near Field Communication". Die Datenübertragung kann ggf. als Datenübertragung mittels induktiver Kopplung und/oder mittels NFC ausgeführt sein. Das Montagebauteil kann z. B. ein Gehäuse mit einer Befestigungsstruktur zur Befestigung am Fahrzeug aufweisen. (Die Befestigungsstruktur weist z. B. ein Rastelement oder eine Öffnung für eine Schraube oder dergleichen auf.)

Vorteilhaft ist es zudem, wenn das Fahrzeug als ein Kraftfahrzeug, insbesondere als ein Hybridfahrzeug oder als ein Elektrofahrzeug ausgebildet ist, vorzugsweise mit einem Hochvolt-Bordnetz und/oder einem Elektromotor. Außerdem kann es möglich sein, dass das Fahrzeug als ein Brennstoffzellenfahrzeug und/oder Personenkraftfahrzeug und/oder semiautonomes oder autonomes Fahrzeug ausgebildet ist.

Vorteilhafterweise weist das Fahrzeug ein Sicherheitssystem auf, welches z. B. durch eine Kommunikation mit einem mobilen Gerät, wie einem Identifikationsgeber (ID-Geber) oder einem Smartphone oder dergleichen eine Authentifizierung ermöglicht. In Abhängigkeit von der Kommunikation und/oder der Authentifizierung kann wenigstens eine Funktion des Fahrzeuges aktiviert werden. Falls hierzu die Authentifizierung des ID-Gebers notwendig ist, kann es sich bei der Funktion um eine sicherheitsrelevante Funktion handeln, wie ein Entriegeln des Fahrzeuges oder eine Freigabe eines Motorstarts. Somit kann das Sicherheitssystem auch als ein passives Zugangssystem ausgebildet sein, welches ohne aktive manuelle Betätigung des ID-Gebers die Authentifizierung und/oder die Aktivierung der Funktion bei Detektion der Annäherung des ID-Gebers an das Fahrzeug initiiert. Hierzu wird bspw. wiederholt ein Wecksignal durch das Sicherheitssystem ausgesendet, welches durch den ID-Geber bei der Annäherung empfangen werden kann, und dann die Authentifizierung auslöst. Auch kann die Funktion eine Aktivierung einer Fahrzeugbeleuchtung und/oder ein Betätigen (Öffnen und/oder Schließen) einer Klappe (z. B. Front- oder Heck- oder Seitenklappe bzw. -tür) betreffen. Bspw. wird automatisch bei der Detektion der Annäherung die Fahrzeugbeleuchtung aktiviert und/oder bei der Detektion einer Geste eines Benutzers die Klappe betätigt. Die Kommunikation des Sicherheitssystems mit dem mobilen Gerät bzw. ID-Geber kann bspw. durch das Montagebauteil ermöglicht werden und/oder die kontaktlose Datenübertragung zwischen dem Fahrzeug und dem mobilen Gerät bzw. ID-Geber umfassen. Ferner kann die Kommunikation als uni- oder bidirektionale Kommunikation ausgeführt sein.

Das Montagebauteil weist wenigstens eine der nachfolgenden (insbesondere elektronischen) Komponenten einer Schaltung auf, welche vorzugsweise auf einer Leiterplatte des Montagebauteils angeordnet sind:
- wenigstens ein elektronisches Verarbeitungsmittel zum Empfangen und/oder Aussenden von (insbesondere elektrischen) Signalen für die (kontaktlose) Datenübertragung über eine Antenne, vorzugsweise über eine NFC-Antenne,
- wenigstens einen Übertragungspfad, um die Antenne für die Datenübertragung mit dem Verarbeitungsmittel zu verbinden, wobei der Übertragungspfad bevorzugt wenigstens eine Leiterbahn aufweist,
- eine Filterschaltung, vorzugsweise zur Ausbildung eines Bandpass-Filters und/oder Bandfilters, welche zumindest zur Bereitstellung einer Bandpass-Filterung in den wenigstens einen Übertragungspfad integriert ist,
- wenigstens eine elektrische (bevorzugt elektronische und/oder kapazitive) Toleranzkompensationseinheit, um Toleranzabweichungen (insbesondere toleranzbedingte Abweichungen bzw. Veränderungen) der Filterschaltung auszugleichen.

Dies hat den Vorteil, dass größere Toleranzen bei der Herstellung und/oder im Betrieb der Filterschaltung möglich sind. In anderen Worten können größere Abweichungen der realen und/oder aktuellen Eigenschaften der Komponenten (insbesondere von Bauteilgrößen wie Kapazität- und/oder Induktivitäts- und/oder Widerstandswerten von Filterelementen der Filterschaltung) von vorgegebenen Eigenschaften z. B. eines Schaltungsentwurfs innerhalb eines festgelegten Toleranzbereiches vorhanden sein, ohne dass hierdurch eine übermäßige Funktionsbeeinträchtigung verursacht wird. Auch kann ggf. das Vorhandensein von Einflusselementen bei dem Montagebauteil toleriert werden, welche die Eigenschaften der Komponenten beeinflussen. Bspw. kann ein Gehäuse des Montagebauteils als Einflusselement Einfluss haben auf die Eigenschaften der Filterschaltung.

Toleranzbedingte Abweichungen können z. B. durch die Toleranzen der als Komponenten eingesetzten elektrischen Bauelemente der Schaltung verursacht werden. Auch können ggf. durch den weiteren Herstellungsprozess und/oder durch den Betrieb und/oder durch Temperaturveränderungen und/oder durch Alterung und/oder durch wenigstens ein Einflusselement des Montagebauteils Veränderungen der Eigenschaften der Filterschaltung verursacht werden. So kann ein Vergießen und/oder die Integration der Filterschaltung in den Türgriff die Filtereigenschaften der Filterschaltung beeinflussen. Damit wird eine Abweichung von der entworfenen Schaltung und damit der idealen Filtereigenschaften und/oder der idealen Komponenteneigenschaften verursacht. Aufgrund der Schwankungen innerhalb eines Toleranzbereiches unterscheidet sich diese Abweichung zudem für unterschiedliche hergestellte Montagebauteile. Dies hat zur Folge, dass eine zuvor vorgegebene Filtereigenschaft, wie die Einstellung des Durchlassbereiches und/oder der Mittenfrequenz bei dem (Betrags-) Frequenzgang, nicht mehr erreicht wird. Ggf. ist die tatsächliche Filtereigenschaft des hergestellten Montagebauteils aufgrund der Toleranz auch nicht vor der Herstellung vorhersehbar. Eine wesentliche Verschiebung der Mittenfrequenz bei geringer Bandbreite ist bei der Bandpassfilterung besonders problematisch, da dies die Datenübertragung deutlich beeinträchtigen kann.

Bspw. kann durch die Toleranzkompensationseinheit gewährleistet werden, dass auch bei solchen Abweichungen die Datenübertragung zuverlässig möglich ist und/oder ein Energieverbrauch bei der Datenübertragung reduziert werden kann. So ist z. B. bei toleranzbedingten Veränderungen bei der Filterschaltung der Stromverbrauch erhöht, weil durch die Veränderungen die Mittenfrequenz (F0) der Filterschaltung von einer vorgegebenen Frequenz abweichen kann, die Betriebsfrequenz (z. B. des Verarbeitungsmittels und/oder der weiteren Schaltung zur Datenübertragung) jedoch weiterhin ("quarzstabil") dieser vorgegebenen Frequenz entspricht. Es kann daher sinnvoll sein, dass die Filterschaltung Frequenzen benachbart zur Mittenfrequenz nicht zu sehr abschwächt (d. h. ein abgeflachtes Plateau um die Mittenfrequenz im Betragsfrequenzgang aufweist) und damit (auch bei toleranzbedingten Abweichungen der Filterelemente) stets einen bestimmten Durchlassbereich mit einer Mindestbreite bzw. eine bestimmte Filterung gewährleistet. Diese Parameter der Filterschaltung können ggf. durch die Toleranzkompensationseinheit eingestellt werden. Auf diese Weise kann der Stromverbrauch gesenkt werden. Die Toleranzkompensationseinheit kann dabei ggf. eine Einstellung der Filterschaltung in der Art ermöglichen, dass die Filterung bzw. dieser Durchlassbereich mit der Mindestbreite auch bei Abweichungen im Toleranzbereich gewährleistet ist. Hierzu kann die Toleranzkompensationseinheit dazu ausgeführt sein, im Idealzustand der Filterschaltung (d. h. ohne Abweichungen von den idealen Komponenteneigenschaften) eine Verschlechterung des Idealzustands des Betragsfrequenzgangs zu bewirken, um beim Auftreten von Abweichungen von diesem Idealzustand der Filterschaltung (bzw. dieser idealen Komponenteneigenschaften) weiterhin einen für die Funktion der Filterschaltung ausreichenden Betragsfrequenzgang bereitzustellen. Diese Funktion kann ggf. kurz als "Toleranzkompensation" bezeichnet werden. Die Verschlechterung ist bspw. ein flacher Verlauf des Betragsfrequenzgangs im Durchlassbereich oder sogar eine Kerbe im Verlauf des Betragsfrequenzgangs bei oder im Bereich der Mittenfrequenz. Diese Verschlechterung wird in Kauf genommen, damit bei Abweichungen der Schaltung von der vorgegebenen Idealparametrisierung dennoch eine ausreichende Filterung gewährleistet ist. Ein besonderer Vorteil kann sich dadurch ergeben, dass die Toleranzkompensationseinheit die Schaltung derart beeinflusst, dass bei toleranzbedingten Abweichungen der Filterschaltung (von dem Idealzustand der Filterschaltung) im Durchlassbereich des Betragsfrequenzgangs der Filterschaltung sich der Verlauf symmetrisch um die Mittenfrequenz verändert. Die Veränderung kann derart sein, dass zwischen einer unteren Grenzfrequenz und der Mittenfrequenz eine Erhöhung, und gleichzeitig zwischen der Mittenfrequenz und der oberen Grenzfrequenz eine Verringerung gegenüber einem idealen Betragsfrequenzgang (ohne Abweichungen) erfolgt, oder umgekehrt. Dies kann auch als "Drehen" des Betragsfrequenzgangs um die Mittenfrequenz bei toleranzbedingten Veränderungen der Filterschaltung verstanden werden. Das "Drehen" kann z. B. durch die Anpassung der Bandbreite der Filterschaltung mittels der Toleranzkompensationseinheit bewirkt werden. Insbesondere wird dies dadurch ermöglicht, dass durch die Toleranzkompensationseinheit ein Verlustfaktor einer der Teilanordnungen, gleich einem Kopplungsfaktor der Filterschaltung, eingestellt wird oder dass im Bereich der Mittenfrequenz eine Abflachung des Betragsfrequenzgangs eingestellt wird.

Bspw. kann die Toleranzkompensationseinheit als ein Kondensator, vorzugsweise Kopplungskondensator, oder dergleichen ausgebildet sein. Auch kann die Toleranzkompensationseinheit derart ausgebildet sein, dass sie in Zusammenwirkung mit Filterelementen der Filterschaltung die Bandpass-Filterung und/oder eine Bandbreiten-Anpassung der Bandpass-Filterung und/oder eine Formung des Betragsfrequenzgangs der Filterschaltung bzw. des Bandpass-Filters und/oder eine kapazitive Kopplung (insbesondere der ersten Teilanordnung mit der zweiten Teilanordnung) bereitstellt.

Die Filterschaltung kann z. B. wenigstens ein Filterelement aufweisen, wie einen Widerstand und/oder eine Spule und/oder einen Kondensator und/oder ein RC-Glied (d. h. einer Verschaltung aus Widerstand und Kondensator) und/oder ein RL-Glied (d. h. einer Verschaltung aus Widerstand und Spule). Auch kann die Filterschaltung ggf. symmetrisch ausgebildet sein, sodass in einem ersten Übertragungspfad eine erste Filteranordnung und in einem zweiten Übertragungspfad eine zweite Filteranordnung vorgesehen sein kann, jeweils mit wenigstens einem Filterelement. Die Filteranordnungen können dabei hinsichtlich ihrer Filterfunktion (insbesondere Übertragungsfunktion) im Wesentlichen gleich sein. Darüber hinaus kann ggf. auch das Verarbeitungsmittel zur Durchführung der kontaktlosen Datenübertragung als eine symmetrische Datenübertragung (oder symmetrische Signalübertragung oder engl. "Differential signaling") ausgebildet sein. Entsprechend kann das Verarbeitungsmittel sowohl mit dem ersten als auch mit dem zweiten Übertragungspfad verbunden sein, um die Signale als komplementäre Signale symmetrisch auszusenden und/oder zu empfangen. Im Übertragungspfad bzw. in den Übertragungspfaden können jeweils eine erste und zweite Teilanordnung vorgesehen sein, welche ggf. miteinander gekoppelt sind. Dabei kann jede Teilanordnung einen Schwingkreis ausbilden. Dies ermöglicht es, eine zuverlässige Filterung für die Datenübertragung bereitzustellen. Die Filterschaltung ist z. B. als Bandfilter oder dergleichen ausgeführt, und wird bspw. aus den wenigstens zwei gekoppelten Teilanordnungen gebildet. Die Teilanordnungen sind jeweils vorteilhafterweise als Schwingkreis ausgebildet. Die wenigstens eine Toleranzkompensationseinheit kann jeweils z. B. zur Kopplung von wenigstens zwei der Teilanordnungen ausgebildet sein.

Die Antenne kann vorteilhafterweise als Spule und/oder als PCB (printed circuit board) Antenne, also gedruckte Antenne, ausgebildet sein. Entsprechend kann die Antenne dazu geeignet sein, eine induktive Kopplung z. B. im Sinne von NFC durchzuführen. Auch das mobile Gerät kann eine korrespondierende Spule aufweisen, sodass die Datenübertragung durch elektromagnetische Induktion mit Hilfe von lose gekoppelten Spulen stattfinden kann.

Das mobile Gerät ist z. B. als ID-Geber, also als ein elektronischer Schlüssel, oder als ein Mobilfunkgerät oder als ein Smartphone oder als ein Tablet oder als ein Laptop oder dergleichen ausgebildet.

Vorteilhafterweise kann der Übertragungspfad wenigstens eine Leiterbahn auf einer Leiterplatte aufweisen, um eine elektrische Verbindung zwischen der Antenne und dem Verarbeitungsmittel herzustellen.

Das elektronische Verarbeitungsmittel ist z. B. als ein Mikrocontroller und/oder als ein NFC-Controller bzw. -Treiber und/oder als ein NFC-Transceiver oder dergleichen ausgebildet.

In einer weiteren Möglichkeit kann vorgesehen sein, dass die wenigstens eine Toleranzkompensationseinheit dazu ausgeführt ist, einen Verlauf eines Betragsfrequenzgangs der Filterschaltung zumindest im Durchlassbereich einzustellen, wobei vorzugsweise der Verlauf als ein im Wesentlichen konstant abfallender und/oder konstant ansteigender Verlauf um eine Mittenfrequenz der Filterschaltung ausgeführt ist. Bspw. kann die Toleranzkompensationseinheit als ein Kondensator ausgebildet sein, dessen Kapazitätswert die Filtereigenschaften und insbesondere die Bandbreite und/oder die kapazitive Kopplung und/oder den Kopplungsfaktor der Filterschaltung beeinflusst. Die Einstellung des Verlaufs kann somit z. B. durch die Veränderung des Kapazitätswerts durchgeführt werden. Auch kann die konkrete Steigung des abfallenden und/oder ansteigenden Verlaufs von den konkreten bauteiltoleranzabhängigen Größen der Bauelemente der Teilanordnungen abhängen. In anderen Worten kann sich für produzierte Montagebauteile der Verlauf unterscheiden, da sich toleranzbedingt die Größen der Bauelemente unterscheiden. Um dennoch eine ausreichende Filterwirkung zu erzielen, kann ggf. die Toleranzkompensationseinheit den Verlauf derart einstellen, dass die toleranzbedingten Veränderungen des Verlaufs berücksichtigt sind. Dies kann z. B. durch eine symmetrische Ausbildung des Verlaufs und/oder mit der Ausbildung eines flachen Verlaufs (d. h. die Steigung entspricht im Wesentlichen 0, wobei bei dem abfallenden oder ansteigenden Verlauf die Steigung deutlich ungleich 0 beträgt) im Bereich der Mittenfrequenz erfolgen. Damit kann die Robustheit gegenüber Bauteiltoleranzen deutlich erhöht werden.

Nach einer weiteren Möglichkeit kann vorgesehen sein, dass die wenigstens eine Toleranzkompensationseinheit dazu ausgeführt ist, einen Betragsfrequenzgang der Filterschaltung im Durchlassbereich mit einem im Wesentlichen symmetrischen Verlauf um eine Mittenfrequenz der Filterschaltung einzustellen. Damit wird eine weitere Lösung bereitgestellt, um die toleranzbedingten Veränderungen des Verlaufs zu berücksichtigen.

Bspw. kann dann die im Wesentlichen vorhandene Symmetrie des Verlaufs dann einer idealen Symmetrie nahezu entsprechen, wenn toleranzbedingte Veränderungen nicht vorhanden sind. Durch die toleranzbedingten Veränderungen kann dann bspw. ein Drehen des Verlaufs um die Mittenfrequenz verursacht werden.

Vorteilhafterweise werden unter "toleranzbedingten Veränderungen" (auch Toleranz bedingte Abweichungen) solche Veränderungen der Komponenten und/oder Bauelemente der Filterschaltung verstanden, welche innerhalb eines Toleranzbereiches z. B. herstellungsbedingt auftreten können. Der Toleranzbereich kann dabei ggf. vordefiniert sein, z. B. in Abhängigkeit von der gewünschten Qualität der verwendeten Bauelemente.

Es kann ferner möglich sein, dass die wenigstens eine Toleranzkompensationseinheit in den wenigstens einen Übertragungspfad integriert ist, und vorzugsweise im jeweiligen Übertragungspfad eine erste und eine zweite Teilanordnung miteinander verbindet (insbesondere induktiv und/oder kapazitiv gekoppelt), um eine Bandbreite der Filterschaltung einzustellen. Hierzu ist die Toleranzkompensationseinheit bspw. als Spule oder Kondensator ausgebildet. Es ist möglich, dass insgesamt zwei Toleranzkompensationseinheiten bei der Filterschaltung vorgesehen sind, eine erste Toleranzkompensationseinheit im ersten Übertragungspfad und eine zweite Toleranzkompensationseinheit im zweiten Übertragungspfad. Dies ermöglicht eine symmetrische Filterung der Signale. Die Teilanordnungen können z. B. jeweils als Schwingkreis ausgebildet sein.

Es ist ferner denkbar, dass die wenigstens eine Toleranzkompensationseinheit dazu ausgeführt ist, einen Betragsfrequenzgang der Filterschaltung im Durchlassbereich mit einem derartigen Verlauf einzustellen, dass die Bandbreite der Filterschaltung mindestens 1 MHz, vorzugsweise mindestens 2 MHz, bevorzugt mindestens 3 MHz, besonders bevorzugt mindestens 4 MHz beträgt. Dies kann bspw. dadurch ermöglicht werden, dass durch Simulationen und/oder durch Messungen bei der Herstellung eine Parametrisierung der Toleranzkompensationseinheit in Abhängigkeit von der Bandbreite erfolgt. Eine größere Bandbreite hat dabei den Vorteil, dass auch bei toleranzbedingten Veränderungen die Übertragung des Signals im gewünschten Frequenzbereich gewährleistet ist.

Außerdem kann es im Rahmen der Erfindung von Vorteil sein, dass die wenigstens eine Toleranzkompensationseinheit dazu ausgebildet ist, einen Kopplungsfaktor (oder Kopplungsgrad) im Wesentlichen gleich einer Dämpfung der Filterschaltung einzustellen, vorzugsweise einen normierten Kopplungsfaktor auf im Wesentlichen 1 einzustellen. Der normierte Kopplungsfaktor ist hierbei insbesondere als das Verhältnis des Kopplungsfaktors zur Dämpfung definiert. Hierdurch wird ein besonders vorteilhafter Frequenzgang und damit eine gegenüber Bauteiltoleranzen robuste Filterung ermöglicht.

Es ist ferner denkbar, dass der wenigstens eine Übertragungspfad als wenigstens eine Leiterbahn einer Leiterplatte ausgebildet ist, und das Verarbeitungsmittel und/oder die Filterschaltung und/oder die Toleranzkompensationseinheit als Elektronikkomponenten auf der Leiterplatte angeordnet sind, wobei die Leiterplatte mit den Elektronikkomponenten von einer Vergussmasse umgeben ist. Die Vergussmasse kann hierbei ein Einflusselement darstellen, welches eine toleranzbedingte Veränderung bewirkt. Gleichzeitig kann die Vergussmasse einen zuverlässigen Schutz der Schaltung bereitstellen.

Vorteilhafterweise kann bei der Erfindung vorgesehen sein, dass die Antenne auf einer Leiterplatte als PCB-Antenne ausgebildet ist und vorzugsweise von einer Vergussmasse umgeben ist. Hierdurch wird eine besonders platzsparende Möglichkeit zur Ausbildung der Antenne bereitgestellt.

Es ist ferner denkbar, dass das Montagebauteil wenigstens ein Gehäuse aufweist, welches das Verarbeitungsmittel und/oder die Filterschaltung und/oder die Toleranzkompensationseinheit jeweils als Elektronikkomponenten umgibt und vorzugsweise eine Vergussmasse der Elektronikkomponenten umgibt, wobei das Gehäuse und/oder die Vergussmasse dazu ausgeführt ist, einen Betragsfrequenzgang der Filterschaltung im Durchlassbereich zu beeinflussen und/oder einzustellen. Damit kann das Montagebauteil in einem montierbaren Zustand vorliegen, z. B. als Türgriff oder dergleichen. Somit kann die Vergussmasse und/oder das Gehäuse als Einflusselement angesehen werden. Vorteilhafterweise ist dabei die Toleranzkompensationseinheit an die Vergussmasse angepasst, sodass der Einfluss der Vergussmasse kompensiert werden kann.

In einer weiteren Möglichkeit kann vorgesehen sein, dass wenigstens ein Gehäuse und/oder eine Vergussmasse vorgesehen sind, welche das Verarbeitungsmittel und/oder die Filterschaltung umgibt, wobei das Gehäuse und/oder die Vergussmasse zumindest Teil der wenigstens eine Toleranzkompensationseinheit sind, um einen Betragsfrequenzgang der Filterschaltung im Durchlassbereich einzustellen. In anderen Worten kann die Toleranzkompensationseinheit als System aus mehreren Komponenten aufgefasst werden, z. B. als System mit einem Kondensator und/oder der Vergussmasse und/oder dem Gehäuse. Die Teile können dabei derart angepasst sein, vorzugsweise bei oder vor einer Herstellung des Montagebauteils, das ein gewünschter Betragsfrequenzgang der Filterschaltung verursacht wird. Der gewünschte Betragsfrequenzgang ist bspw. ein Betragsfrequenzgang gemäß einer kritischen Kopplung (des Bandfilters). Vorteilhafterweise ist der Betragsfrequenzgang vordefiniert, sodass die Herstellung des Montagebauteils anhand einer Vorgabe des Betragsfrequenzgangs durchgeführt werden kann.

Gemäß einem weiteren Vorteil kann vorgesehen sein, dass der wenigstens eine Übertragungspfad als wenigstens zwei Übertragungspfade ausgebildet ist, um eine symmetrische Signalübertragung der Signale zwischen der Antenne und dem Verarbeitungsmittel bereitzustellen, wobei vorzugsweise die wenigstens eine Toleranzkompensationseinheit als jeweils ein Koppelelement zur Signalkopplung der Signale in den jeweiligen Übertragungspfaden ausgebildet ist, um insbesondere einen Betragsfrequenzgang der Filterschaltung im Durchlassbereich mit einem im Wesentlichen symmetrischen Verlauf um eine Mittenfrequenz der Filterschaltung einzustellen. Insbesondere durch toleranzbedingte Veränderungen kann es zu einer Veränderung dieses symmetrischen Verlaufs kommen, z. B. zu einer Drehung des Verlaufs um die Mittenfrequenz. Die Toleranzkompensation kann dabei den Vorteil haben, dass durch die toleranzbedingten Veränderungen in einem Frequenzbereich unterhalb der Mittenfrequenz der Verlauf eine Erhöhung aufweist, und in einem Frequenzbereich oberhalb der Mittenfrequenz der Verlauf eine Verringerung aufweist, oder umgekehrt. In anderen Worten kann sich der Verlauf symmetrisch um die Mittenfrequenz verändern, wenn toleranzbedingte Veränderungen auftreten. Insbesondere bei der Nutzung der symmetrischen Signalübertragung hat dies den weiteren Vorteil, dass es nicht auf die Übertragung exakt bei der Mittenfrequenz ankommt, sondern symmetrisch hierzu eine Kompensation erfolgen kann.

Ferner ist es optional vorgesehen, dass die Filterschaltung, vorzugsweise eine jeweilige Filteranordnung, als Bandpassfilter mit einer Mittenfrequenz für eine NFC-Frequenz, vorzugsweise von zumindest nahezu 13,56 MHz, ausgeführt ist. Damit kann zuverlässig NFC zur Datenübertragung genutzt werden. Insbesondere ermöglicht dies z. B.den Einsatz von Smartphones als ID-Geber bzw. als mobiles Gerät.

Es ist ferner denkbar, dass die Antenne als Nahfeldantenne ausgeführt ist. Damit ist eine kontaktlose Datenübertragung zuverlässig möglich.

In einer weiteren Möglichkeit kann vorgesehen sein, dass der wenigstens einen Übertragungspfad als wenigstens ein erster und zweiter gegenüberliegender (das heißt dem ersten gegenüberliegenden) Übertragungspfad auf einer Leiterplatte ausgebildet ist, um die Antenne für die Datenübertragung symmetrisch mit dem Verarbeitungsmittel zu verbinden. Alternativ oder zusätzlich kann die wenigstens eine Toleranzkompensationseinheit als eine erste Toleranzkompensationseinheit im ersten Übertragungspfad und eine zweite Toleranzkompensationseinheit im zweiten Übertragungspfad ausgebildet sein. Dabei kann an den Übertragungspfaden jeweils eine Filteranordnung der Filterschaltung integriert sein, um die Filterung gleichartig für die Übertragungspfade bereitzustellen, wobei vorteilhafterweise jede der Filteranordnungen eine erste und eine zweite Teilanordnung aufweist, welche über jeweils eine der Toleranzkompensationseinheiten miteinander verbunden sind, um einen Frequenzgang der Filterschaltung einzustellen. Damit ist eine zuverlässige Filterung möglich.

Gemäß einem weiteren Vorteil kann vorgesehen sein, dass an (d. h. auch integriert in) den Übertragungspfaden jeweils eine Filteranordnung der Filterschaltung vorgesehen ist, wobei die Filteranordnungen jeweils eine erste Teilanordnung in der Form eines seriellen Schwingkreises und eine zweite Teilanordnung in der Form eines parallelen Schwingkreises aufweisen, welche vorzugsweise über jeweils eine Toleranzkompensationseinheit, bevorzugt jeweils ein Koppelelement, besonders bevorzugt jeweils einen Kopplungskondensator, miteinander verbunden sind. Dies ermöglicht es, über die Toleranzkompensationseinheit zuverlässig eine Bandbreite und/oder einen Verlauf des Betragsfrequenzganges der Filterschaltung einzustellen.

Ferner ist es bei dem erfindungsgemäßen Montagebauteil denkbar, dass die wenigstens eine Toleranzkompensationseinheit (jeweils) als Koppelelement, vorzugsweise als Kopplungskondensator, ausgebildet ist, um die Bandbreite einzustellen. Hierzu kann das Koppelelement z. B. gemäß einer induktiven und/oder kapazitiven Kopf- oder Fußpunktkopplung verschaltet sein und/oder die erste Teilanordnung mit der zweiten Teilanordnung verbinden.

Auch kann ggf. die jeweilige Filteranordnung dazu ausgeführt sein, die Filterung derart gleichartig für die Übertragungspfade als Bandmaß und/oder Bandfilter bereitzustellen, dass ein Betragsfrequenzgang der Filterschaltung einen Verlauf mit (im Wesentlichen) konstanter Steigung im Durchlassbereich aufweist.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: eine schematische Seitenansicht eines Fahrzeuges mit einem erfindungsgemäßen Montagebauteil,
- Fig. 2: ein schematisches Schaltbild von Teilen eines erfindungsgemäßen Montagebauteils,
- Fig. 3: eine schematische Darstellung von Teilen eines erfindungsgemäßen Montagebauteils,
- Fig. 4: eine weitere schematische Darstellung von Teilen eines erfindungsgemäßen Montagebauteils und
- Fig. 5: mehrere schematische Betragsfrequenzgänge einer Filterschaltung des Montagebauteils.

In den nachfolgenden Figuren werden für die gleichen technischen Merkmale auch von unterschiedlichen Ausführungsbeispielen die identischen Bezugszeichen verwendet.

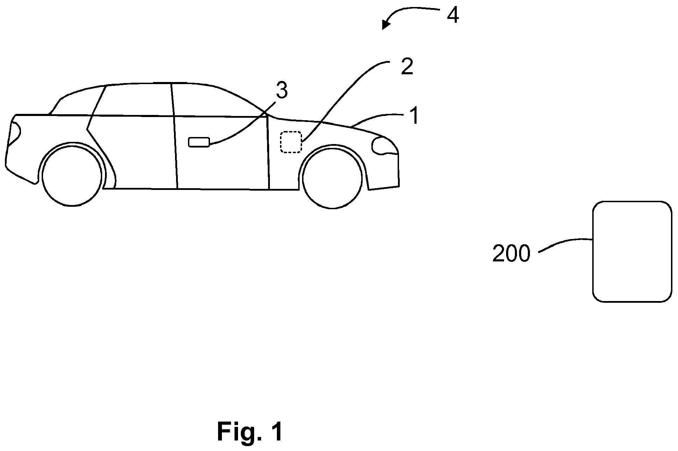

In Fig. 1 gezeigt ist eine schematische Seitenansicht eines Fahrzeuges 1 mit einer Fahrzeugelektronik 2 und einer Fahrzeugkomponente 3 wie einem Türgriff 3. Die Fahrzeugelektronik 2 weist z. B. ein Sicherheitssystem 4 auf, um ein mobiles Gerät 200 zu authentifizieren. Für die zur Authentifizierung notwendige Kommunikation kann ein erfindungsgemäßes Montagebauteil 100 beim Fahrzeug 1 vorgesehen sein, welches insbesondere als die Fahrzeugkomponente 3 ausgebildet ist.

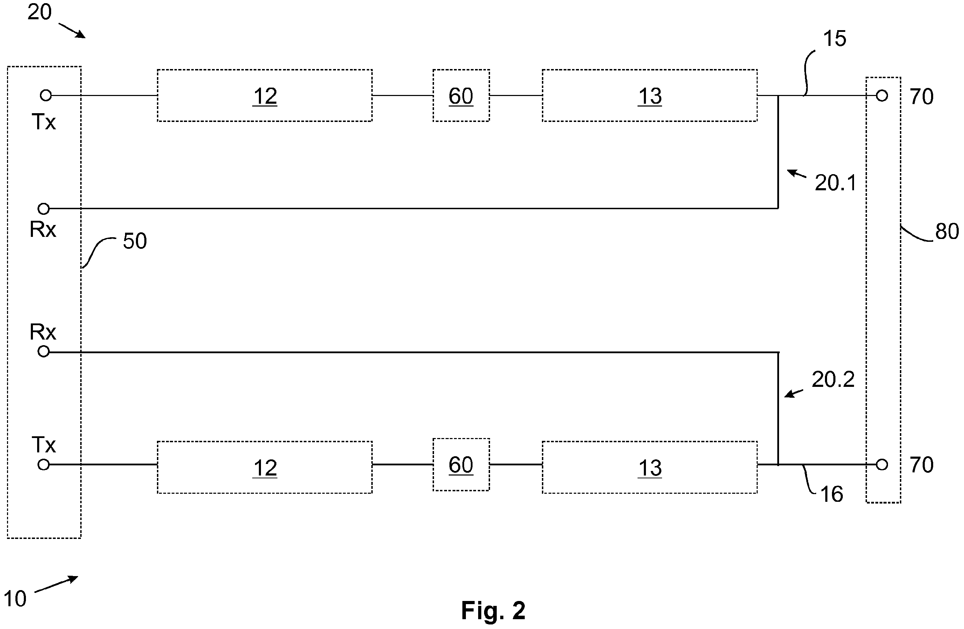

In Fig. 2 ist schematisch ein Schaltbild einer Schaltung des erfindungsgemäßen Montagebauteils 100 gezeigt. Das erfindungsgemäße Montagebauteil 100 ist zur kontaktlosen Datenübertragung zwischen dem Fahrzeug 1 und einem mobilen Gerät 200 ausgeführt und kann bevorzugt zur NFC-Kommunikation dienen. Es kann dabei wenigstens ein elektronisches Verarbeitungsmittel 50 zum Empfangen und/oder Aussenden von Signalen für die Datenübertragung über eine Antenne 80 aufweisen. Es handelt sich hierbei z. B. um einen integrierten Schaltkreis, welcher zur Bereitstellung einer NFC-Kommunikation ausgebildet ist. Derartige Verarbeitungsmittel 50 werden z. B. in der Form von Mikrocontrollern angeboten. Ferner kann wenigstens ein Übertragungspfad 14 genutzt werden, um die Antenne 80 für die Datenübertragung mit dem Verarbeitungsmittel 50 zu verbinden. Außerdem kann eine Filterschaltung 20 bei dem erfindungsgemäßen Montagebauteil 100 vorgesehen sein, welche zumindest zur Bereitstellung einer Bandpass-Filterung in den wenigstens einen Übertragungspfad 14 integriert ist, z. B. mit Leiterbahnen als Übertragungspfad 14 verbunden sind. Es ist außerdem wenigstens eine elektrische Toleranzkompensationseinheit 60 vorgesehen, um Toleranzabweichungen der Filterschaltung 20 auszugleichen. Diese Toleranzabweichungen sind z. B. toleranzbedingte Veränderungen der Bauelemente der Filterschaltung 20.

Die wenigstens eine Toleranzkompensationseinheit 60 kann in den wenigstens einen Übertragungspfad 14 integriert sein, und im jeweiligen Übertragungspfad 14 eine jeweilige erste 12 und zweite 13 Teilanordnung miteinander verbinden, um eine Bandbreite B der Filterschaltung 20 einzustellen.

Es ist im Rahmen der Erfindung möglich, dass der wenigstens eine Übertragungspfad 14 als wenigstens ein erster 15 und zweiter 16 gegenüberliegender Übertragungspfad auf einer Leiterplatte 11 ausgebildet ist, um die Antenne 80 für die Datenübertragung symmetrisch mit dem Verarbeitungsmittel 50 zu verbinden. Auf diese Weise kann eine symmetrische Signalübertragung bereitgestellt werden, z. B. zwischen einer Verbindungsanordnung 70 der Antenne 80 und symmetrischen, komplementären Anschlüssen Rx, Tx des Verarbeitungsmittels 50. Rx kann hierbei ein Anschluss zum Empfangen und Tx zum Senden von Signalen ausgehend von dem Verarbeitungsmittel 50 sein. Außerdem ist es möglich, dass die wenigstens eine Toleranzkompensationseinheit 60 als eine erste Toleranzkompensationseinheit 60 im ersten Übertragungspfad 15 und eine zweite Toleranzkompensationseinheit 60 im zweiten Übertragungspfad 16 ausgebildet ist, wobei an den Übertragungspfaden 14 jeweils eine Filteranordnung 20.1, 20.2 der Filterschaltung 20 integriert ist, um die Filterung gleichartig für die Übertragungspfade 14 bereitzustellen. Jede der Filteranordnungen 20.1, 20.2 kann ggf. eine erste 12 und eine zweite Teilanordnung 13 aufweisen, welche über jeweils eine der Toleranzkompensationseinheiten 60 miteinander verbunden sind, um einen Frequenzgang der Filterschaltung 20 einzustellen.

Darüber hinaus kann an den Übertragungspfaden 14 jeweils eine Filteranordnung 20.1, 20.2 der Filterschaltung 20 vorgesehen sein. Hierbei können die Filteranordnungen 20.1, 20.2 jeweils eine erste Teilanordnung 12 in der Form eines seriellen Schwingkreises und eine zweite Teilanordnung 13 in der Form eines parallelen Schwingkreises aufweisen, welche über jeweils eine Toleranzkompensationseinheit 60, vorzugsweise jeweils ein Koppelelement 60, bevorzugt jeweils einen Kopplungskondensator 60, miteinander verbunden sind, insbesondere kapazitiv gekoppelt sind.

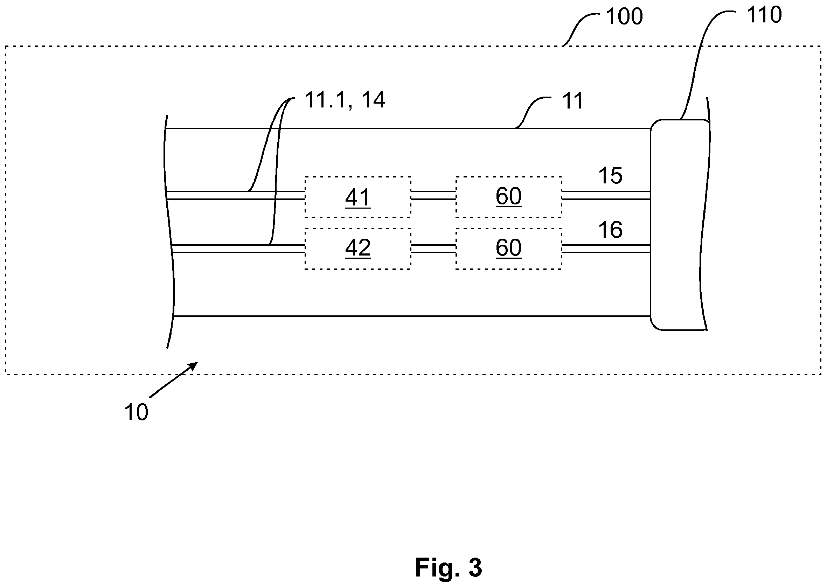

In Fig. 3 ist schematisch eine Draufsicht auf eine Leiterplatte 11 gezeigt, welche zwei parallel verlaufende Leiterbahnen 11.1 aufweist. Es ist dargestellt, dass zur Ausbildung einer Filterschaltung 20 wenigstens ein Filterelement 41 in einem ersten Übertragungspfad 15 und wenigstens ein weiteres Filterelement 42 in einem zweiten Übertragungspfad 16 integriert sein kann. Bei diesen Filterelementen 41, 42 kann es sich z. B. um elektronische Bauelemente wie Widerstände oder Kondensatoren oder Spulen handeln. Das jeweilige Filterelement 41, 42 kann dabei mit der Toleranzkompensationseinheit 60 verbunden sein. Diese Toleranzkompensationseinheit 60 ist bspw. als Kondensator 60 mit der Leiterbahn 11.1 verbunden. Ferner ist dargestellt, dass durch die räumliche Nähe der Filterelemente 41, 42 zu einem Gehäuse 110 und/oder zu weiteren Einflusselementen des Montagebauteils 100 toleranzbedingte Veränderungen hervorgerufen werden können.

Ferner kann der wenigstens eine Übertragungspfad 14 als wenigstens eine Leiterbahn 11.1 einer Leiterplatte 11 ausgebildet sein, und zumindest das Verarbeitungsmittel 50, die Filterschaltung 20 und die Toleranzkompensationseinheit 60 jeweils als Elektronikkomponenten auf der Leiterplatte 11 angeordnet sein. Die derart ausgebildete Leiterplatte 11 mit den Elektronikkomponenten kann eine Elektronikvorrichtung 10 des Montagebauteils 100 ausbilden.

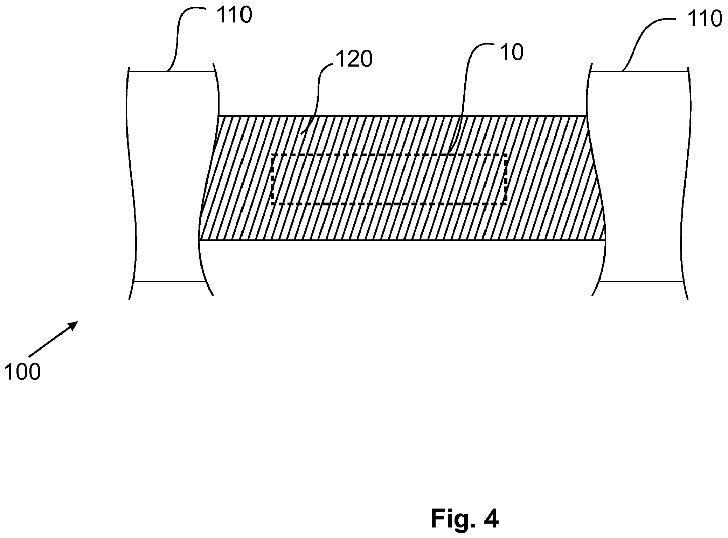

Gemäß Fig. 4 kann die Elektronikvorrichtung 10 zumindest teilweise von einer Vergussmasse 120 umgeben sein. Es ist ferner möglich, dass die Antenne 80 auf einer Leiterplatte 11 als PCB-Antenne ausgebildet ist, und von einer Vergussmasse 120 umgeben oder davon ausgenommen ist. Darüber hinaus ist auch ein Gehäuse 110 des Montagebauteils 100 in Fig. 4 dargestellt, welche als Einflusselement die toleranzbedingten Veränderungen bewirken kann.

Ferner kann das Gehäuse 110 ggf. das Verarbeitungsmittel 50, die Filterschaltung 20 und die Toleranzkompensationseinheit 60 umgeben und vorzugsweise ebenfalls die Vergussmasse 120 umgeben. Das Gehäuse 110 und/oder die Vergussmasse 120 können als Einflusselemente dazu ausgeführt sein, einen Betragsfrequenzgang G der Filterschaltung 20 im Durchlassbereich D zu beeinflussen und/oder einzustellen. Es kann von Vorteil sein, wenn wenigstens das Gehäuse 110 und/oder die Vergussmasse 120 vorgesehen sind, und das Verarbeitungsmittel 50 und/oder die Filterschaltung 20 umgeben, wobei das Gehäuse 110 und/oder die Vergussmasse 120 zumindest Teil der wenigstens einen Toleranzkompensationseinheit 60 sind, um einen Betragsfrequenzgang G der Filterschaltung 20 im Durchlassbereich D einzustellen.

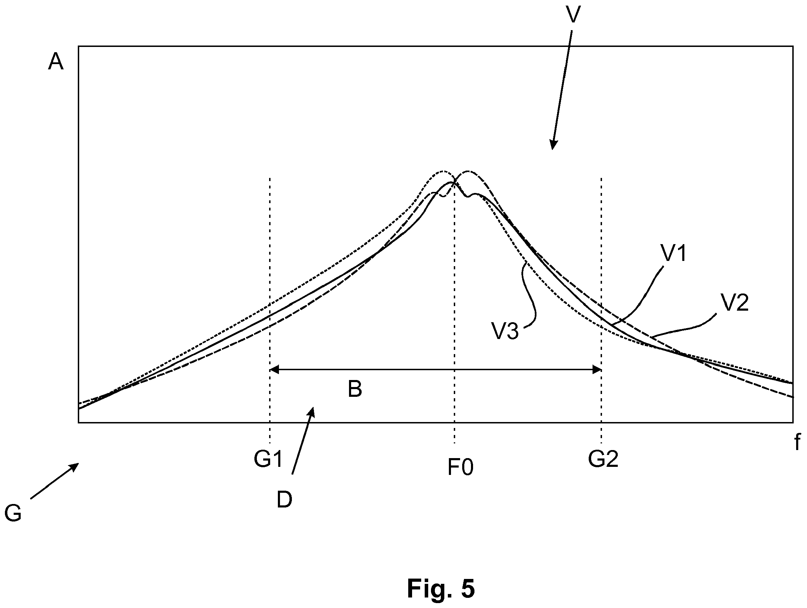

Wie in Fig. 5 dargestellt ist, kann die wenigstens eine Toleranzkompensationseinheit 60 dazu ausgeführt sein, einen Betragsfrequenzgang G der Filterschaltung 20 im Durchlassbereich D mit einem im Wesentlichen konstant abfallenden oder konstant ansteigenden Verlauf V um eine Mittenfrequenz F0 der Filterschaltung 20 einzustellen. Alternativ oder zusätzlich kann die wenigstens eine Toleranzkompensationseinheit 60 dazu ausgeführt sein, einen Betragsfrequenzgang G der Filterschaltung 20 im Durchlassbereich D mit einem im Wesentlichen symmetrischen Verlauf V um eine Mittenfrequenz F0 der Filterschaltung 20 einzustellen.

Vorteilhafterweise kann die wenigstens eine Toleranzkompensationseinheit 60 dazu geeignet sein, einen Betragsfrequenzgang G der Filterschaltung 20 im Durchlassbereich D mit einem derartigen Verlauf V einzustellen, dass die Bandbreite B der Filterschaltung 20 mindestens 1 MHz, vorzugsweise mindestens 2 MHz, bevorzugt mindestens 3 MHz, besonders bevorzugt mindestens 4 MHz beträgt. Es ist denkbar, dass die wenigstens eine Toleranzkompensationseinheit 60 dazu ausgebildet ist, einen Kopplungsfaktor im Wesentlichen gleich einer Dämpfung der Filterschaltung 20 einzustellen, vorzugsweise einen normierten Kopplungsfaktor auf im Wesentlichen 1 einzustellen.

Für die zuvor beschriebenen Anpassungen kann die Toleranzkompensationseinheit 60 bspw. hinsichtlich ihrer elektrischen Eigenschaften parametrisiert werden, z. B. anhand der Beurteilung mittels einer Simulation.

Die entsprechende Ausbildung der Toleranzkompensationseinheit 60 hat den Vorteil, dass der durch die Toleranzkompensationseinheit 60 eingestellte Durchlassbereich D und/oder die Bandbreite B eine Toleranz für Frequenzabweichungen aufweist. Ein besonderer Vorteil wird erzielt, wenn ein "Drehen" des Verlaufs V um die Mittenfrequenz F0 bei toleranzbedingten Veränderungen der Filtereigenschaften der Filterschaltung 20 auftritt. So ist beispielhaft in Fig. 5 ein erster Verlauf V1, ein zweiter Verlauf V2 und ein dritter Verlauf V3 gezeigt, welcher jeweils für unterschiedliche Filtereigenschaften vorliegen kann. Die unterschiedlichen Filtereigenschaften werden bspw. durch die toleranzbedingten Veränderungen bewirkt. Es ist beispielhaft an dem Verlauf V3 erkennbar, dass durch die Veränderungen gegenüber V1 und V2 ein Anstieg der Amplitude A des Verlaufs V3 im Bereich zwischen einer unteren Grenzfrequenz G1 und der Mittenfrequenz F0 und gleichzeitig ein Abfall der Amplitude A des Verlaufs V3 im Bereich zwischen einer oberen Grenzfrequenz G2 und der Mittenfrequenz F0 erfolgt.

Die Filterschaltung 20, vorzugsweise eine jeweilige Filteranordnung 20.1, 20.2, kann ggf. als Bandpassfilter mit einer Mittenfrequenz F0 für eine NFC-Frequenz, vorzugsweise von zumindest nahezu 13,56 MHz ausgeführt sein.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: Fahrzeug
- 2: Fahrzeugelektronik
- 3: Fahrzeugkomponente, Türgriff
- 4: Sicherheitssystem

- 10: Vorrichtung, NFC-Schnittstellenvorrichtung
- 11: Leiterplatte
- 11.1: Leiterbahn
- 12: erste Teilanordnung, erster Schwingkreis, serieller Schwingkreis
- 13: zweite Teilanordnung, zweiter Schwingkreis, paralleler Schwingkreis
- 14: Übertragungspfad
- 15: erster Übertragungspfad
- 16: zweiter Übertragungspfad

- 20: Filterschaltung
- 20.1: erste Filteranordnung
- 20.2: zweite Filteranordnung

- 41: Filterelement
- 42: weiteres Filterelement

- 50: Verarbeitungsmittel

- 60: Toleranzkompensationseinheit

- 70: Verbindungsanordnung

- 80: Antenne

- 100: Montagebauteil
- 110: Gehäuse

- 120: Vergussmasse

- 200: mobiles Gerät

- f: Frequenz
- A: Amplitude
- B: Bandbreite
- D: Durchlassbereich
- F0: Mittenfrequenz
- G: Betragsfrequenzgang, Amplitudenfrequenzgang
- G1: untere Grenzfrequenz
- G2: obere Grenzfrequenz
- Rx: Receiver-Anschluss
- Tx: Transmitter-Anschluss
- V: Verlauf

## Patentansprüche

1. Montagebauteil (100), insbesondere ein Türgriff (3), für ein Fahrzeug (1) zur kontaktlosen Datenübertragung zwischen dem Fahrzeug (1) und einem mobilen Gerät (200), vorzugsweise zur NFC-Kommunikation, aufweisend:
- wenigstens ein elektronisches Verarbeitungsmittel (50) zum Empfangen und/oder Aussenden von Signalen für die Datenübertragung über eine Antenne (80),
- wenigstens einen Übertragungspfad (14), um die Antenne (80) für die Datenübertragung mit dem Verarbeitungsmittel (50) zu verbinden,
- eine Filterschaltung (20), welche zumindest zur Bereitstellung einer Bandpass-Filterung in den wenigstens einen Übertragungspfad (14) integriert ist,
- wenigstens eine elektrische Toleranzkompensationseinheit (60), um Toleranzabweichungen der Filterschaltung (20) auszugleichen.

2. Montagebauteil (100) nach Anspruch 1,
**dadurch gekennzeichnet,**
**dass** die wenigstens eine Toleranzkompensationseinheit (60) dazu ausgeführt ist, einen Verlauf eines Betragsfrequenzgangs (G) der Filterschaltung (20) im Durchlassbereich (D) einzustellen.

3. Montagebauteil (100) nach Anspruch 1 oder 2,
**dadurch gekennzeichnet,**
**dass** die wenigstens eine Toleranzkompensationseinheit (60) dazu ausgeführt ist, einen Betragsfrequenzgang (G) der Filterschaltung (20) im Durchlassbereich (D) mit einem im Wesentlichen symmetrischen Verlauf (V) um eine Mittenfrequenz (F0) der Filterschaltung (20) einzustellen.

4. Montagebauteil (100) nach einem der vorhergehenden Ansprüche,
**dadurch gekennzeichnet,**
**dass** die wenigstens eine Toleranzkompensationseinheit (60) in den wenigstens einen Übertragungspfad (14) integriert ist, und im jeweiligen Übertragungspfad (14) eine erste (12) und eine zweite Teilanordnung (13) miteinander verbindet, um eine Bandbreite (B) der Filterschaltung (20) einzustellen.

5. Montagebauteil (100) nach einem der vorhergehenden Ansprüche,
**dadurch gekennzeichnet,**
**dass** die wenigstens eine Toleranzkompensationseinheit (60) dazu ausgeführt ist, einen Betragsfrequenzgang (G) der Filterschaltung (20) im Durchlassbereich (D) mit einem derartigen Verlauf (V) einzustellen, dass die Bandbreite (B) der Filterschaltung (20) mindestens 1 MHz, vorzugsweise mindestens 2 MHz, bevorzugt mindestens 3 MHz, besonders bevorzugt mindestens 4 MHz beträgt.

6. Montagebauteil (100) nach einem der vorhergehenden Ansprüche,
**dadurch gekennzeichnet,**
**dass** die wenigstens eine Toleranzkompensationseinheit (60) dazu ausgebildet ist, einen Kopplungsfaktor im Wesentlichen gleich einer Dämpfung der Filterschaltung (20) einzustellen, vorzugsweise einen normierten Kopplungsfaktor auf im Wesentlichen 1 einzustellen.

7. Montagebauteil (100) nach einem der vorhergehenden Ansprüche,
**dadurch gekennzeichnet,**
**dass** der wenigstens eine Übertragungspfad (14) als wenigstens eine Leiterbahn (11.1) einer Leiterplatte (11) ausgebildet ist, und das Verarbeitungsmittel (50), die Filterschaltung (20) und die Toleranzkompensationseinheit (60) als Elektronikkomponenten auf der Leiterplatte (11) angeordnet sind, wobei die Leiterplatte (11) mit den Elektronikkomponenten von einer Vergussmasse (120) umgeben ist.

8. Montagebauteil (100) nach einem der vorhergehenden Ansprüche,
**dadurch gekennzeichnet,**
**dass** die Antenne (80) auf einer Leiterplatte (11) als PCB-Antenne ausgebildet ist.

9. Montagebauteil (100) nach einem der vorhergehenden Ansprüche,
**dadurch gekennzeichnet,**
**dass** das Montagebauteil (100) wenigstens ein Gehäuse (110) aufweist, welches das Verarbeitungsmittel (50), die Filterschaltung (20) und die Toleranzkompensationseinheit (60) als Elektronikkomponenten umgibt, und vorzugsweise eine Vergussmasse (120) der Elektronikkomponenten umgibt, wobei das Gehäuse (110) und/oder die Vergussmasse (120) dazu ausgeführt ist, einen Betragsfrequenzgang (G) der Filterschaltung (20) im Durchlassbereich (D) zu beeinflussen und/oder einzustellen.

10. Montagebauteil (100) nach einem der vorhergehenden Ansprüche,
**dadurch gekennzeichnet,**
**dass** wenigstens ein Gehäuse (110) und/oder eine Vergussmasse (120) vorgesehen sind, welche das Verarbeitungsmittel (50) und/oder die Filterschaltung (20) umgibt, wobei das Gehäuse (110) und/oder die Vergussmasse (120) zumindest Teil der wenigstens einen Toleranzkompensationseinheit (60) sind, um einen Betragsfrequenzgang (G) der Filterschaltung (20) im Durchlassbereich (D) einzustellen.

11. Montagebauteil (100) nach einem der vorhergehenden Ansprüche,
**dadurch gekennzeichnet,**
**dass** der wenigstens eine Übertragungspfad (14) als wenigstens zwei Übertragungspfade (15, 16) ausgebildet ist, um eine symmetrische Signalübertragung der Signale zwischen der Antenne (80) und dem Verarbeitungsmittel (50) bereitzustellen, wobei die wenigstens eine Toleranzkompensationseinheit (60) als jeweils ein Koppelelement (60) zur Signalkopplung der Signale in den jeweiligen Übertragungspfaden (14) ausgebildet ist, um einen Betragsfrequenzgang (G) der Filterschaltung (20) im Durchlassbereich (D) mit einem im Wesentlichen symmetrischen Verlauf (V) um eine Mittenfrequenz (F0) der Filterschaltung (20) einzustellen.

12. Montagebauteil (100) nach einem der vorhergehenden Ansprüche,
**dadurch gekennzeichnet,**
**dass** die Filterschaltung (20), vorzugsweise eine jeweilige Filteranordnung (20.1, 20.2), als Bandpassfilter mit einer Mittenfrequenz (F0) für eine NFC-Frequenz, vorzugsweise von zumindest nahezu 13,56 MHz ausgeführt ist.

13. Montagebauteil (100) nach einem der vorhergehenden Ansprüche,
**dadurch gekennzeichnet,**
**dass** die Antenne (80) als Nahfeldantenne ausgeführt ist.

14. Montagebauteil (100) nach einem der vorhergehenden Ansprüche,
**dadurch gekennzeichnet,**
**dass** der wenigstens eine Übertragungspfad (14) als wenigstens ein erster (15) und zweiter (16) gegenüberliegender Übertragungspfad auf einer Leiterplatte (11) ausgebildet ist, um die Antenne (80) für die Datenübertragung symmetrisch mit dem Verarbeitungsmittel (50) zu verbinden, und dass
die wenigstens eine Toleranzkompensationseinheit (60) als eine erste Toleranzkompensationseinheit (60) im ersten Übertragungspfad (15) und eine zweite Toleranzkompensationseinheit (60) im zweiten Übertragungspfad (16) ausgebildet ist, wobei
an den Übertragungspfaden (14) jeweils eine Filteranordnung (20.1, 20.2) der Filterschaltung (20) integriert ist, um die Filterung gleichartig für die Übertragungspfade (14) bereitzustellen, wobei
jede der Filteranordnungen (20.1, 20.2) eine erste (12) und eine zweite Teilanordnung (13) aufweist, welche über jeweils eine der Toleranzkompensationseinheiten (60) miteinander verbunden sind, um einen Frequenzgang der Filterschaltung (20) einzustellen.

15. Montagebauteil (100) nach einem der vorhergehenden Ansprüche,
**dadurch gekennzeichnet,**
**dass** an den Übertragungspfaden (14) jeweils eine Filteranordnung (20.1, 20.2) der Filterschaltung (20) vorgesehen ist, wobei die Filteranordnungen (20.1, 20.2) jeweils eine erste Teilanordnung (12) in der Form eines seriellen Schwingkreises und eine zweite Teilanordnung (13) in der Form eines parallelen Schwingkreises aufweisen, welche über jeweils eine Toleranzkompensationseinheit, vorzugsweise jeweils ein Koppelelement, bevorzugt jeweils einen Kopplungskondensator, miteinander verbunden sind.
